(19) Europäisches Patentamt
European Patent Office
Office européen des brevets

(11) **EP 4 535 639 A1**

(12) **EUROPEAN PATENT APPLICATION**
published in accordance with Art. 153(4) EPC

(43) Date of publication:
09.04.2025 Bulletin 2025/15

(21) Application number: 23810796.5

(22) Date of filing: 06.05.2023

(51) International Patent Classification (IPC):
*H02M 7/5387* (2007.01)   *H02M 1/12* (2006.01)
*H02J 3/38* (2006.01)

(52) Cooperative Patent Classification (CPC):
**G06F 30/367; H02M 1/0058; H02M 7/4807;**
H02J 2300/24; H02M 7/53878; Y02E 10/56

(86) International application number:
**PCT/CN2023/092409**

(87) International publication number:
**WO 2023/226723 (30.11.2023 Gazette 2023/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 26.05.2022 CN 202210590607

(71) Applicant: Shanghai Jiao Tong University
Shanghai 200240 (CN)

(72) Inventors:
• LI, Rui
Shanghai 200240 (CN)
• YANG, Jiatao
Shanghai 200240 (CN)

(74) Representative: **Qip Patentanwälte**
**Dr. Kuehn & Partner mbB**
**Bavariaring 10**
**80336 München (DE)**

(54) **CIRCUIT MODELING METHOD AND OUTPUT CURRENT CONTROL METHOD FOR DUAL-ACTIVE-BRIDGE-TYPE MICRO-INVERTER**

(57)    Provided in the present invention is a circuit modeling method for a dual-active-bridge-type micro-inverter. The method equates dual-active-bridge-type micro-inverter to a standard dual-active-bridge circuit by establishing an equivalent circuit model, thereby establishing a third-order large signal model and a third-order small signal model of the micro-inverter, so as to facilitate the solution of a circuit state variable and the analysis of the dynamic performance. On the one hand, the method facilitates the solution of the steady-state operating point, and on the other hand, the transfer function obtained using the small signal model facilitates the study of the dynamic performance of the micro-inverter. Further provided in the present invention is an output current control method for a dual-active-bridge-type micro-inverter. By means of the method, a correct current loop control logic is established on the basis of a small signal model of a dual-active-bridge-type micro-inverter, and a current loop parameter design method is given. The method is conducive to improving the grid-connection stability and the precision of the output current of the micro-inverter, by giving the correct current loop control logic and the detailed current loop parameter design method.

Figure 5

**Description**

**TECHNICAL FIELD**

The present invention relates to the field of photovoltaic micro-inverter technology, and specifically to a circuit modeling method and an output current control method applicable to a dual-active-bridge-type micro-inverter.

**BACKGROUND**

Micro-inverter generally refers to an inverter with a power of less than or equal to 1000W in a photovoltaic power generation system and having maximum power point tracking capability at the component level. Unlike centralized and string type PV inverter systems, micro-inverters are directly connected to individual PV components. Its advantage is that it can perform independent MPPT control on each component, which can significantly improve the overall efficiency and at the same time avoid the problems of DC high voltage, poor weak light effect and barrel effect, etc. that exist in centralized inverters.

According to the position and structural characteristics of the DC bus, micro-inverters can be classified into three main categories: DC bus structure, pseudo DC bus structure and no DC bus structure. Wherein the micro inverter without DC bus is a single-stage circuit that adopts matrix control, which is more advantageous because of the small number of switching devices used and high conversion efficiency. And in the micro-inverter without DC bus structure, the Dual Active Bridge (DAB) type micro inverter uses the least number of switching devices, which also improves the problem of low efficiency of DAB circuits at light loads on the basis of the wide-range soft-switching characteristics of DAB circuits.

At present, there are literature modeling standard DAB circuits, but the circuit model is only applicable to DC-DC type DAB converters and cannot be applied to DAB-type micro-inverters. In addition, the current loop closed-loop control compensator for DAB-type micro-inverters in the current literature is either a proportional controller or a proportional-integral controller, and the current loop control logic does not change with changes in the grid-side voltage. Therefore, it is necessary to provide a circuit modeling method suitable for DAB-type micro-inverters and provide a reasonable current loop control logic based on this modeling method in order to achieve closed-loop control of micro-inverter circuits and improve the output current accuracy and grid-connection stability.

After searching, it was found that:

The Chinese invention patent application "Small signal modeling method for grid-connection asymmetric cascaded H-bridge converter system" with the publication number CN109408904A, derives a small signal model of the power circuit based on a simplified model of grid-connection asymmetric cascaded H-bridge multilevel converter; derives the perturbation differential equations of the grid current $i_g$, the grid current reference signal $i_{g,ref}$, the reference signal of the filtering capacitor current, and the modulation signal $u_m$, etc. in the control system; calculates the output voltage $v_i$ of the grid-connection asymmetrical cascaded H-bridge multilevel converter and derives the small signal model of the system without phase-locked loop; derives the small signal model of the phase-locked loop, and establishes the small signal model of the entire grid-connection asymmetrical cascaded H-bridge multilevel converter system. This method is also applicable to the off-grid asymmetrical cascaded H-bridge multilevel converter system. However, this method still has the following problems if it is applied to the circuit modeling of DAB-type micro-inverters:

Firstly, the DAB-type micro-inverter belongs to a high-frequency chain AC/DC conversion system, and its working principle is fundamentally different from that of a cascaded H-bridge multilevel converter, and the high-frequency transformer primary and secondary side voltages and transformer currents of the DAB-type micro-inverter are both AC components, thus it is unable to directly model the circuit using the modeling method in the above mentioned patent, but rather need to equivalent these AC electrical quantities; secondly, unlike the cascaded H-bridge multilevel converter, the transfer function gain of the DAB-type micro-inverter will change with changes in DC side voltage, AC side instantaneous voltage, and instantaneous transmission power. Therefore, this modeling method cannot accurately model the DAB-type micro-inverters.

The Chinese invention patent "Negative sequence voltage compensation dual-loop control method and system based on virtual synchronous generator" with the authorized publication number CN109193707B, wherein the voltage loop uses a quasi-proportional resonance regulator to suppress the harmonic components of the output voltage, and the current loop uses a proportional control to accelerate the response speed of the system. However, this method still has the following problems if it is applied to the closed-loop control of the output current of the DAB-type micro-inverters:

Firstly, only the current loop is required in the control loop of the DAB-type micro-inverters, and in order to realize the accurate control of the grid-connection current and the suppression of the harmonic waves of the grid-connection current, it is necessary to use a quasi-proportional resonance regulator, and it is unable to effectively eliminate the control errors by using the proportional control of the above mentioned patent; secondly, unlike the above mentioned patent, the current error generation stage of the DAB-type micro-inverter is closely related to the positive and negative of the grid-side voltage, and it is necessary to change the generation logic of the current error according to the sampled grid-side voltage, otherwise the control system will be unstable. Therefore, this method cannot effectively control the current of the DAB-type micro-inverters.

**SUMMARY**

Aiming at the above mentioned shortcomings in the prior art, it is provided a circuit modeling method and an output current control method applicable to a dual-active-bridge-type micro-inverter.

According to one aspect of the present invention, a circuit modeling method for a dual-active-bridge-type micro-inverter is provided, which equates the micro-inverter to a standard dual-active-bridge(DAB)-type circuit by establishing an equivalent circuit model for the dual-active-bridge-type micro-inverter, thereby further establishing a large signal model and a small signal model for the micro-inverter, completing the circuit modeling of the dual-active-bridge-type micro-inverter; wherein:

Establishing an equivalent circuit model for the dual-active-bridge-type micro-inverter, comprising:

Constructing a DC source $V_{oc}$, a DC source series resistor $R_{pv}$, a DC side bus capacitor $C_{bus}$, a controlled current source $i_{ac,in}$, an ideal transformer with a primary side to a secondary side turn ratio of 1:n, a controlled current source $i_{ac,out}$, a capacitor $C_g$, a filtering inductor $L_g$ on a AC power grid side, an inductor winding resistor $R_L$, and a DC pulsating source $|v_g|$; the positive pole of the DC source $V_{oc}$ is connected with one end of the DC source series resistor $R_{pv}$, the other end of DC source series resistor $R_{pv}$ is connected with the positive pole of the DC side bus capacitor $C_{bus}$, the positive pole of the DC side bus capacitor $C_{bus}$ is simultaneously connected with the positive pole of the primary side of the ideal transformer, the negative pole of the primary side of the ideal transformer is connected with the negative pole of the DC source $V_{oc}$, the positive pole of the secondary side of the ideal transformer is connected with the negative pole of the controlled current source $i_{ac,in}$, the negative pole of the secondary side of the ideal transformer is connected with the positive pole of the controlled current source $i_{ac,in}$ and simultaneously connected with the negative pole of the controlled current source $i_{ac,out}$, the positive pole of the controlled current source $i_{ac,out}$ is connected with the positive pole of the capacitor $C_g$ and simultaneously connected with one end of the filtering inductor $L_g$ on the AC power grid side, the other end of the inductor $L_g$ on the AC power grid side is connected with one end of the inductor winding resistor $R_L$, and the other end of the inductor winding resistor $R_L$ is connected with the positive pole of the DC pulsating source $|v_g|$, and the negative pole of the DC pulsating source $|v_g|$ is connected with the negative pole of the capacitor $C_g$;

The established large signal model for the micro-inverter is: a third-order average model $X = A_1X + B_1U$; wherein $X$ is a state variable of the large signal model; $X$ is a derivative of the state variable of the large signal model with respect to time; $U$ is an input variable of the large signal model; $A_1$ is a coefficient matrix of the state variable of the large signal model, with an order of $3 \times 3$; $B_1$ is a coefficient matrix of the input variable of the large signal model, with an order of $3 \times 2$; the state variable $X$ of the large signal model is: $X = [\langle v_{bus}\rangle, \langle v_{cg}\rangle, \langle i_o\rangle]^T$; the input variable $U$ of the large signal model is: $U = [\langle v_{dc}\rangle, \langle v_o\rangle]^T$; wherein $\langle v_{bus}\rangle$ is an average value of the voltage of the DC side bus capacitor $C_{bus}$ of the equivalent circuit during the switching period, $\langle v_{cg}\rangle$ is an average value of the voltage of the capacitor $C_g$ of the equivalent circuit during the switching period, $\langle i_o\rangle$ is an average value of the output current of the equivalent circuit during the switching period, $\langle v_{dc}\rangle$ is an average value of the input voltage of the DC side of the equivalent circuit during the switching period, and $\langle v_o\rangle$ is an average value of the output voltage of the equivalent circuit during the switching period;

The established small signal model for the micro-inverter is: a third-order model $\dot{x} = A_2x + B_2u$; wherein $x$ is a state variable of the small signal model; $\dot{x}$ is a derivative of the state variable of the small signal model; $u$ is an input variable of the small signal model; $A_2$ is a coefficient matrix of the state variable of the small signal model, with an order of $3 \times 3$; $B_1$ is a coefficient matrix of the input variable of the small signal model, with an order of $3 \times 4$; the state variable $x$ of the small signal model is: $x = \left[\widehat{v_{bus}}, \widehat{v_{cg}}, \hat{i}_o\right]^T$; the input variable $u$ of the small signal model is:

$u = \left[\widehat{v_{dc}}, \widehat{v_o}, \widehat{d_1}, \widehat{d_2}\right]^T$; wherein $\widehat{v_{bus}}$ is a perturbation value of the voltage of the DC side bus capacitor

$C_{bus}$ of the equivalent circuit, $\widehat{v_{cg}}$ is a perturbation value of the voltage of the capacitor $C_g$ of the equivalent circuit, $\hat{i}_o$ is a perturbation value of the output current of the equivalent circuit, $\widehat{v_{dc}}$ is a perturbation value of the input voltage of the DC side of the equivalent circuit, $\widehat{v_o}$ is a perturbation value of the output voltage of the equivalent circuit, $\widehat{d_1}$ is a perturbation value of the internal phase shift angle, $\widehat{d_2}$ is a perturbation value of the external phase shift angle.

Optionally, in the equivalent circuit model of the dual-active-bridge-type micro-inverter, the voltage of the DC source $V_{oc}$ is the open-circuit voltage of the photovoltaic panels; the DC source series resistor $R_{pv}$ is equal to the output voltage of the photovoltaic panels at the point of maximum power divided by the output current; the output currents of the controlled current source $i_{ac,in}$ and the controlled current source $i_{ac,out}$ vary according to the different modulation modes of the dual-active-bridge-type micro-inverter;

The DC pulsating source $|v_g|$ is the output voltage of the equivalent circuit model, and the output current of the equivalent circuit model $i_o$ is equal to $i_s \cdot \text{sgn}(v_g)$, wherein $i_g$ is a sampled grid-side current, and $\text{sgn}(v_g)$ is a sign function of the grid-side voltage.

Optionally, the large signal model of the micro-inverter is used to solve the variation relationship of the state variable $X$ with the input variable $U$, the variation relationship obtained by solving is used to analyze the steady-state operating point of the circuit, and the small signal model is solved and analyzed at the obtained steady-state operating point.

Optionally, the small signal model of the micro-inverter is used to solve a transfer function from four input variables to three state variables, further used to analyze the grid-connection stability and dynamic performance of the micro-inverter under different circuit parameters and operating conditions; wherein:

The four input variables are $u = \left[ \widehat{v_{dc}}, \ \widehat{v_o}, \ \widehat{d_1}, \ \widehat{d_2} \right]^T$, the three state variables are $x = \left[ \widehat{v_{bus}}, \ \widehat{v_{cg}}, \ \widehat{i_o} \right]^T$, and the expression of the transfer function is:

$$x = (sI - A_2)^{-1} B_2 u$$

Wherein $I$ is a diagonal matrix with diagonal element 1, with an order of $3 \times 3$; s is the Laplace domain symbol; and the expressions of the matrices $A_2$ and $B_2$ are:

$$A_2 = \begin{bmatrix} -\dfrac{1}{R_{pv}C_{bus}} & -\dfrac{\alpha}{C_{bus}} & 0 \\[2mm] \dfrac{\alpha}{C_g} & 0 & -\dfrac{1}{C_g} \\[2mm] 0 & \dfrac{1}{L_g} & -\dfrac{R_L}{L_g} \end{bmatrix}$$

$$B_2 = \begin{bmatrix} \dfrac{1}{R_{pv}C_{bus}} & 0 & \dfrac{\beta|v_g|}{C_{bus}} & -\dfrac{\gamma|v_g|}{C_{bus}} \\[2mm] 0 & 0 & -\dfrac{\beta V_{bus}}{C_g} & \dfrac{\gamma V_{bus}}{C_g} \\[2mm] 0 & -\dfrac{1}{L_g} & 0 & 0 \end{bmatrix}$$

Wherein $V_{bus}$ is the DC bus capacitor voltage, $R_{pv}$ is the output voltage of the photovoltaic panels at the point of maximum power divided by the output current, $L_g$ is the filtering inductor on the AC power grid side, and the symbolic variables $\alpha$, $\beta$ and $\gamma$ are related to the modulation mode of the dual-active-bridge-type micro-inverter.

For analyzing the grid-connection stability and dynamic performance of micro-inverters under different circuit parameters and operating conditions, comprising:

The transfer function from the input variable to the state variable is solved according to the small signal model of the micro-inverter, and the transfer function can be used to describe the quantitative variation relationship of the state variable $x$ with the input variable $u$ at different frequencies, and when the transfer function is known, then the response of the state variable can be studied for various forms of input variables, in order to analyze the grid-connection stability of the micro-inverter.

The three parameters of photovoltaic terminal voltage $v_{pv}$, power grid voltage amplitude $V_m$ and grid-connection power $P_o$ are changed, and under each set of parameters ($v_{pv}$, $V_m$, $P_o$), the transfer function from the input variables to the state variables is solved according to the small signal model of the micro-inverter and the dynamic performance of the micro-inverter is analyzed according to the gain, crossover frequency, amplitude margin, and phase margin of the transfer function.

Optionally, the modulation mode of the dual-active-bridge-type micro-inverter, comprising:

The angle between the negative rising edge of the transformer primary side square wave voltage and the positive rising edge of the transformer primary side square wave voltage is positioned as the internal phase shift angle $D_1$, the angle between the fundamental wave of the transformer primary side square wave voltage and the fundamental wave of the transformer secondary side square wave voltage is defined as the external phase shift angle $D_2$, and the internal phase shift angle $D_1$ and the external phase shift angle $D_2$ are taken as two control degrees of freedom for the dual-active-bridge-type micro-inverter, wherein the range of values of $D_1$ is $0 \leq D_1 \leq 0.5$, and the range of values of $D_2$ is $-0.5 \leq D_2 \leq 0.5$;

According to the two control degrees of freedom, the modulation mode of transmission power is divided into mode one, mode two and mode three, wherein: when the external phase shift angle $D_2$ satisfies $(1 - D_1)/2 < D_2 \leq 0.5$ or $-0.5 < D_2 \leq -(1 - D_1)/2$, the positive electrical level part of the primary side square wave voltage completely coincides with the negative level part of the secondary side square wave voltage, the corresponding modulation mode is mode one, at this time, the output currents of the controlled current source $i_{ac,in}$ and the controlled current source $i_{ac,out}$ are close to a sine wave, and the effective value of output current is maximum; when the external phase shift angle $D_2$ satisfies $0 \leq D_2 \leq D_1/2$ or $-D_1/2 \leq D_2 \leq 0$, the positive electrical level part of the primary side square wave voltage completely coincides with the positive level part of the secondary side square wave voltage, the corresponding modulation mode is mode three, at this time, the output currents of the controlled current source $i_{ac,in}$ and the controlled current source $i_{ac,out}$ are close to a triangular wave, and the effective value of output current is minimum; when the external phase shift angle $D_2$ satisfies $D_1/2 < D_2 \leq (1 - D_1)/2$ or $-(1 - D_1)/2 < D_2 \leq -D_1/2$, one part of the positive electrical level of the primary side square wave voltage coincides with the positive electrical level of the secondary side square wave voltage, the other part of the positive electrical level of the primary side square wave voltage coincides with the negative electrical level of the secondary side square wave voltage, the corresponding modulation mode is mode two, at this time, the output currents of the controlled current source $i_{ac,in}$ and the controlled current source $i_{ac,out}$ are close to a trapezoidal wave, the effective value of the output current is less than the effective value in mode one and greater than the effective value in mode three.

Optionally, for the mode two, the symbol variables $\alpha$, $\beta$ and $\gamma$ are respectively:

$$\begin{cases} \alpha = \dfrac{n(2D_2 - D_1^2 - 4D_2^2)}{4f_s L_k} \\[2ex] \beta = \dfrac{\partial \alpha}{\partial D_1} = -\dfrac{n \cdot 2D_1}{4f_s L_k} \\[2ex] \gamma = \dfrac{\partial \alpha}{\partial D_2} = \dfrac{n \cdot (2 - 8D_2)}{4f_s L_k} \end{cases}$$

For the mode three, the symbol variables $\alpha$, $\beta$ and $\gamma$ are respectively:

$$\begin{cases} \alpha = \dfrac{n \cdot 2D_2(1 - 2D_1)}{4f_s L_k} \\[2ex] \beta = \dfrac{\partial \alpha}{\partial D_1} = -\dfrac{n \cdot 4D_2}{4f_s L_k} \\[2ex] \gamma = \dfrac{\partial \alpha}{\partial D_2} = \dfrac{n \cdot 2(1 - 2D_1)}{4f_s L_k} \end{cases}$$

Wherein $f_s$ is the switching frequency of the switching tube, $L_k$ is the value of the transformer leakage inductor converted to the secondary side, n is the transformer secondary-primary turns ratio, $D_1$ and $D_2$ are the internal and external phase shift angles, respectively.

According to another aspect of the present invention, an output current control method of a dual-active-bridge-type micro-inverter is provided, based on the small signal model of the micro-inverter established by the circuit modeling method according to any one of the above mentioned, a control logic of the current loop is determined according to the positive and negative of the grid-side voltage, a grid-side current error is obtained through the determined control logic and inputted to a current closed-loop compensation controller, and the output of the current closed-loop compensation controller is an external phase shift angle $D_2$ of the micro-inverter, and phase shift control is carried out through the external phase shift angle $D_2$ to accomplish closed-loop control of the output current of the dual-active-bridge-type micro-inverter; wherein:

The control logic of the current loop comprises:

When the power grid voltage $v_g$ is less than 0, the grid-side current error is $(i_g - i_{g,ref})$, wherein $i_g$ is the sampled grid-side current, and $i_{g,ref}$ is the given value of the grid-side current;

When the power grid voltage $v_g$ is greater than 0, the grid-side current error is $(i_{g,ref} - i_g)$.

Optionally, the current closed-loop compensation controller uses a quasi-proportional resonant controller, and the quasi-proportional resonance controller has three control parameters, respectively: a bandwidth adjustment parameter $\omega_c$, a proportionality coefficient $K_p$ and a resonance coefficient $K_r$; wherein:

The bandwidth adjustment parameter $\omega_c$: is used to change the resonance bandwidth of the frequency band characteristics of the current closed-loop compensation controller, the smaller $\omega_c$ is, the better the frequency selection characteristics are, but the worse the ability to resist power grid frequency disturbance is;

The proportionality coefficient $K_p$: is used to improve the dynamic characteristics of the dual-active-bridge-type micro-inverter control system, the larger $K_p$ is, the shorter the response time is, but the larger the overshoot is;

The resonance coefficient $K_r$: is used to adjust the gain of the current closed-loop compensation controller, the larger $K_r$ is, the larger the controller gain is.

Optionally, the design method for the control parameters of the quasi-proportional resonance controller, comprising:

According to the small signal model of the dual-active-bridge-type micro-inverter, obtaining the current loop open-loop transfer function $G_{io,d2}(s)$ from the external phase shift angle $D_2$ to the output current at the set time during the power frequency period; selecting the open-loop gain of the current loop at the power frequency $\omega_{ac}$ to be greater than or equal to $M$; selecting the crossover frequency of the current loop open-loop transfer function to be $\omega_{cr}$; and selecting the phase margin of the current loop open-loop transfer function to be greater than or equal to $\phi_{margin}$;

According to the maximum allowable variation range of the power grid angular frequency $[-\Delta\omega_{max}, \Delta\omega_{max}]$, taking $\omega_c = \Delta\omega_{max}$, wherein $\Delta\omega_{max}$ is the maximum allowable variation of the power grid angular frequency;

Obtaining the current loop open-loop transfer function $T_c(j\omega_{ac}) = G_{io,d2}(j\omega_{ac}) \cdot G_{QPR}(j\omega_{ac})$ at the power frequency $\omega_{ac}$ according to the current loop open-loop transfer function $G_{io,d2}(s)$ and the transfer function $G_{QPR}(s)$ of the quasi-proportional resonance controller, wherein j is an imaginary unit, letting the gain of the current loop open-loop transfer function $T_c (j\omega_{ac})$ at the power frequency $\omega_{ac}$ be greater than or equal to $M$, obtaining an inequality constraint relationship $|G_{io,d2}(j\omega_{ac}) \cdot G_{QPR}(j\omega_{ac})| \geq M$ containing the proportionality coefficient $K_p$ and the resonance coefficient $K_r$;

According to the property that the current loop has a gain of 1 at the crossover frequency $\omega_{cr}$, obtaining an equality constraint relationship $|G_{io,d2}(j\omega_{cr}) \cdot G_{QPR}(j\omega_{cr})| = 1$ containing the proportionality coefficient $K_p$ and the resonance coefficient $K_r$;

According to the condition that the phase margin of the current loop at the crossover frequency $\omega_{cr}$ needs to be greater than or equal to $\phi_{margin}$, obtaining an inequality constraint relationship $\pi + angle [G_{io,d2}(j\omega_{cr}) \cdot G_{QPR}(j\omega_{cr})] \geq \phi_{margin}$ containing $K_p$ and $K_r$;

According to the two inequality constraints relationship and one equality constraint relationship obtained above, the range of the proportionality coefficient $K_p$ and the resonance coefficients $K_r$ can be solved, and the control parameters can be obtained accordingly.

Optionally, further comprising:

When $|v_g| \leq 10V$ is satisfied near the zero crossing point of the grid-side voltage, the current error of the input current closed-loop compensation controller is set to 0;

When the power grid voltage $v_g$ is less than $-10V$, the current error of the grid-side is $(i_g - i_{g,ref})$;

When the power grid voltage $v_g$ is greater than $10V$, the current error of the grid-side is $(i_{g,ref} - i_g)$.

Due to the adoption of the above technical solution, the present invention has at least one of the following beneficial effects compared to the prior art:

The circuit modeling method of a dual-active-bridge-type micro-inverter provided by the present invention establishes a complete third-order micro-inverter large signal and small signal model. On the one hand, the method facilitates the solution of the steady-state operating point, and on the other hand, the small signal model enables further study the grid-connection stability and dynamic performance of the micro-inverter, and provides guidance for the design of control parameters.

The output current control method of a dual-active-bridge-type micro-inverter provided by the present invention gives a correct current loop control logic and an exhaustive current loop parameter design method, which is conducive to improving the grid-connection stability and output current accuracy of the micro-inverter.

The circuit modeling method of a dual-active-bridge-type micro-inverter provided by the present invention can achieve accurate modeling of a DAB-type micro-inverter.

The output current control method of a dual-active-bridge-type micro-inverter provided by the present invention can better control the current of a DAB-type micro-inverter.

## BRIEF DESCRIPTION OF THE DRAWINGS

Other features, objects and advantages of the present invention will become more apparent by reading the detailed description of the non-limiting embodiments with reference to the following accompanying drawings:

FIG.1 shows a schematic diagram of a single-stage half-bridge DAB-type micro-inverter circuit in a preferred embodiment of the present invention;

FIG.2 shows a schematic diagram of the driving signals of switching tubes S1~S8 under three modulation modes in a preferred embodiment of the present invention, and the waveforms of the transformer primary side voltage, the transformer secondary side voltage, and the transformer secondary side current, when the direction of the power transmission is from the DC side to the AC side and the grid-side voltage is positive;

FIG.3 shows a schematic diagram of the range of internal phase shift angle and external phase shift angle corresponding to the three modulation modes in a preferred embodiment of the present invention;

FIG.4 shows a schematic diagram of an equivalent circuit of dual-active-bridge-type micro-inverter in a preferred embodiment of the present invention;

FIG.5 shows an overall control block diagram of dual-active-bridge-type micro-inverter in a preferred embodiment of the present invention.

## DETAILED DESCRIPTION OF EMBODIMENTS

The present invention is described in detail below in conjunction with specific embodiments. The following embodiments will help those skilled in the art to further understand the present invention, but do not limit the present invention in any form. It should be pointed out that for those ordinary skilled in the art, a number of deformations and improvements can be made without departing from the conception of the present invention, all of which fall within the scope of protection of the present invention. The parts not described hereinafter may be referred to the records in the content of the invention or the prior art.

An embodiment of the present invention provides a circuit modeling method of a dual-active-bridge-type micro-inverter, which equates the micro-inverter to a standard dual-active-bridge-type circuit(DAB-type circuit) by establishing an equivalent circuit model for the dual-active-bridge-type micro-inverter, thereby further establishing a third-order large signal model and a small signal model of the micro-inverter, completing the circuit modeling of the dual-active-bridge-type micro-inverter, so as to facilitate the solution of a circuit state variable, and then achieving the analysis of the grid-connection stability and dynamic performance of the micro-inverter.

In this embodiment, the dual-active-bridge-type micro-inverter, comprising: a photovoltaic panel, a DC side bus capacitor, a primary side square wave generating circuit, a high frequency transformer, a secondary side square wave generating circuit, a filtering capacitor $C_g$, a filtering inductor $L_g$ on the AC grid-side, and a series damping resistor $R_L$; the positive and negative poles of the photovoltaic panel are connected with the positive and negative poles of the DC side bus capacitor respectively, and the positive and negative poles of the DC side bus capacitor are connected with the positive and negative poles of DC side port of the primary side square wave generating circuit respectively, the positive and negative poles of the AC side port of the primary side square wave generating circuit are connected with the positive and negative poles of the input port of the high frequency transformer respectively, and the AC side port of the secondary side square wave generating circuit are connected with the positive and negative poles of the output port of the high frequency transformer respectively, the positive pole of the DC side port of the secondary side square wave generating circuit is connected with the filtering inductor $L_g$ on the AC grid-side, and the filtering inductor $L_g$ on the AC grid-side is connected in series with the series damping resistor $R_L$ and is connected to the positive pole of the AC grid; the negative pole of the DC side port of the secondary side square wave generating circuit is connected with the negative pole of the AC grid; wherein, the turn ratio of the primary side to the secondary side of the high frequency transformer is 1:n, and the leakage inductor converted to the secondary side of the dual-active-bridge-type micro-inverter transformer is $L_k$.

The dual-active-bridge-type micro-inverter transformer can output three electrical levels $\{v_{pv}, 0, -v_{pv}\}$ on the

**EP 4 535 639 A1**

primary side, and can output two electrical levels $\{|v_g|/2, -|v_g|/2\}$ on the secondary side. Wherein $v_{pv}$ is the photovoltaic panel terminal voltage and $|v_g|$ is the absolute value of the grid-side voltage.

The dual-active-bridge-type micro-inverter realizes the output power regulation by phase shift modulation, and the micro-inverter has two control degrees of freedom, which are the internal phase shift angle $D_1$ of the primary side circuit and the external phase shift angle $D_2$ of the primary side and secondary side circuits respectively, wherein the internal phase shift angle is defined as the angle between the negative rising edge of the primary side square wave voltage and the positive rising edge of the primary side square wave voltage, and the external phase shift angle is defined as the angle between the fundamental wave of the transformer primary side square wave voltage and the fundamental wave of the transformer secondary side square wave voltage. The range of values for $D_1$ is $0 \le D_1 \le 0.5$, and the range of values for $D_2$ is $-0.5 \le D_2 \le 0.5$.

Furthermore, according to the two control degrees of freedom of the micro-inverter, there are three modulation modes of phase shift modulation for the dual-active-bridge-type micro-inverter to realize the regulation of the output power, which are classified according to the range of values for the internal phase shift angle $D_1$ and the external phase shift angle $D_2$. When $D_2$ satisfies $(1 - D_1)/2 < D_2 \le 0.5$ or $-0.5 < D_2 \le -(1- D_1)/2$, the positive electrical level part of the primary side voltage completely coincides with the negative level part of the secondary side voltage, the corresponding modulation mode is mode one, at this time, the transformer current is close to a sine wave, and the effective value of the transformer current is maximum, but the zero-voltage soft switch of the primary and secondary switch tubes is most easily achieved; when $D_2$ satisfies $D_1/2 < D_2 \le (1- D_1)/2$ or $-(1- D_1)/2 < D_2 \le -D_1/2$, one part of the positive electrical level of the primary side voltage coincides with the positive electrical level of the secondary side voltage, the other part of the positive electrical level of the primary side voltage coincides with the negative electrical level of the secondary side voltage, the corresponding modulation mode is mode two, at this time, the transformer current is close to a trapezoidal wave, the effective value of the transformer current is moderate, i.e., it is smaller than the effective value of mode one and larger than the effective value of mode three, and the zero-voltage soft switch of the primary and secondary switch tubes is easier to realize, i.e., the degree of ease is smaller than the degree of ease of mode one and larger than the degree of ease of mode three; when the external phase shift angle $D_2$ satisfies $0 \le D_2 \le D_1/2$ or $-D_1/2 \le D_2 \le 0$, the positive electrical level part of the primary side voltage completely coincides with the positive level part of the secondary side square wave voltage, the corresponding modulation mode is mode three, at this time, the transformer current is close to a triangle wave, and the effective value of the transformer current is minimum, but the zero-voltage soft switch of the primary and secondary switch tubes is most difficult to achieve.

In a preferred embodiment, establishing an equivalent circuit model for the dual-active-bridge-type micro-inverter comprises: constructing a DC source $V_{oc}$, a DC source series resistor $R_{pv}$, a DC side bus capacitor $C_{bus}$, a controlled current source $i_{ac,in}$, an ideal transformer with primary and secondary side turn ratio of 1:n, a controlled current source $i_{ac,out}$, a capacitor $C_g$, a filtering inductor $L_g$ on a AC power grid side, an inductor winding resistor $R_L$, and a DC pulsating source $|v_g|$; the positive pole of the DC source $V_{oc}$ is connected with one end of the DC source series resistor $R_{pv}$, the other end of DC source series resistor $R_{pv}$ is connected with the positive pole of the DC side bus capacitor $C_{bus}$, the positive pole of the DC side bus capacitor $C_{bus}$ is simultaneously connected with the positive pole of the primary side of the ideal transformer, the negative pole of the primary side of the ideal transformer is connected with the negative pole of the DC source $V_{oc}$, the positive pole of the secondary side of the ideal transformer is connected with the negative pole of the controlled current source $i_{ac,in}$, the negative pole of the secondary side of the ideal transformer is connected with the positive pole of the controlled current source $i_{ac,in}$ and simultaneously connected with the negative pole of the controlled current source $i_{ac,out}$, the positive pole of the controlled current source $i_{ac,out}$ is connected with the positive pole of the capacitor $C_g$ and simultaneously connected with one end of the filtering inductor $L_g$ on the AC power grid side, the other end of the inductor $L_g$ on the AC power grid side is connected with one end of the inductor winding resistor $R_L$, and the other end of the inductor winding resistor $R_L$ is connected with the positive pole of the DC pulsating source $|v_g|$, and the negative pole of the DC pulsating source $|v_g|$ is connected with the negative pole of the capacitor $C_g$.

Wherein:

The voltage of the DC source $V_{oc}$ is the open-circuit voltage of the photovoltaic panels; the DC source series resistor $R_{pv}$ is equal to the output voltage of the photovoltaic panels at the point of maximum power divided by the output current; the output currents of the controlled current source $i_{ac,in}$ and the controlled current source $i_{ac,out}$ (i.e. the transformer currents) vary according to the different modulation modes of the dual-active-bridge-type micro-inverter.

The output voltage of the constructed equivalent circuit is $|v_g|$ and the output current $i_o$ is equal to $i_s \cdot \text{sgn}(v_g)$, wherein $i_g$ is a sampled grid-side current, and $\text{sgn}(v_g)$ is a sign function of the grid-side voltage.

In a preferred embodiment, the large signal model for the micro-inverter is a third-order average model $\dot{X} = A_1 X + B_1 U$. Wherein $X$ is a state variable of the large signal model; $\dot{X}$ is a derivative of the state variable of the large signal model with respect to time; $U$ is an input variable of the large signal model; $A_1$ is a coefficient matrix of the state variable of the large signal model, with an order of $3 \times 3$; $B_1$ is a coefficient matrix of the input variable of the large signal model, with an order of $3 \times 2$.

Wherein:

The state variable $X$ of the large signal model is: $X = [\langle v_{bus}\rangle, \langle v_{cg}\rangle, \langle i_o\rangle]^T$; the input variable $U$ of the large signal model is: $U = [\langle v_{dc}\rangle, \langle v_o\rangle]^T$; wherein $\langle v_{bus}\rangle$ is an average value of the voltage of the DC side bus capacitor $C_{bus}$ of the equivalent circuit during the switching period, $\langle v_{cg}\rangle$ is an average value of the voltage of the capacitor $C_g$ of the equivalent circuit during the switching period, $\langle i_o\rangle$ is an average value of the output current of the equivalent circuit during the switching period, $\langle v_{dc}\rangle$ is an average value of the input voltage of the DC side of the equivalent circuit during the switching period, and $\langle v_o\rangle$ is an average value of the output voltage of the equivalent circuit during the switching period.

The large signal model of the micro-inverter is used to solve the variation relationship of the state variable $X$ with the input variable $U$, the solved variation relationship is used to analyze the steady-state operating point of the circuit, and the small signal model is solved and analyzed at the obtained steady-state operating point.

In a preferred embodiment, the small signal model for the micro-inverter is: a third-order model $\dot{x} = A_2 x + B_2 u$; wherein $x$ is a state variable of the small signal model; $\dot{x}$ is a derivative of the state variable of the small signal model; $u$ is an input variable of the small signal model; $A_2$ is a coefficient matrix of the state variable of the small signal model, with an order of $3\times 3$; $B_1$ is a coefficient matrix of the input variable of the small signal model, with an order of $3 \times 4$.

Wherein:

The state variable $x$ of the small signal model is: $x = \left[\widehat{v_{bus}},\ \widehat{v_{cg}},\ \widehat{i_o}\right]^T$; the input variable $u$ of the small signal model is:

$u = \left[\widehat{v_{dc}},\ \widehat{v_o},\ \widehat{d_1},\ \widehat{d_2}\right]^T$; wherein $\widehat{v_{bus}}$ is a perturbation value of the voltage of the DC side bus capacitor $C_{bus}$ of the

equivalent circuit, $\widehat{v_{cg}}$ is a perturbation value of the voltage of the capacitor $C_g$ of the equivalent circuit, $\widehat{i_o}$ is a perturbation value of the output current of the equivalent circuit, $\widehat{v_{dc}}$ is a perturbation value of the input voltage of the DC side of the equivalent circuit, $\widehat{v_o}$ is a perturbation value of the output voltage of the equivalent circuit, $\widehat{d_1}$ is a perturbation value of the internal phase shift angle, $\widehat{d_2}$ is a perturbation value of the external phase shift angle.

The small signal model of the dual-active-bridge-type micro-inverter can be used to solve a transfer function from four input variables to three state variables, further used to analyze the grid-connection stability and dynamic performance of the micro-inverter under different circuit parameters and operating conditions.

The four input variables are $u = \left[\widehat{v_{dc}},\ \widehat{v_o},\ \widehat{d_1},\ \widehat{d_2}\right]^T$, the three state variables are $x = \left[\widehat{v_{bus}},\ \widehat{v_{cg}},\ \widehat{i_o}\right]^T$, and the expression of the transfer function is:

$$x = \left(sI - A_2\right)^{-1} B_2 u$$

Wherein $I$ is a diagonal matrix with diagonal element 1, with an order of $3 \times 3$; s is the Laplace domain symbol; and the expressions of the matrices $A_2$ and $B_2$ are:

$$A_2 = \begin{bmatrix} -\dfrac{1}{R_{pv}C_{bus}} & -\dfrac{\alpha}{C_{bus}} & 0 \\[3mm] \dfrac{\alpha}{C_g} & 0 & -\dfrac{1}{C_g} \\[3mm] 0 & \dfrac{1}{L_g} & -\dfrac{R_L}{L_g} \end{bmatrix}$$

$$B_2 = \begin{bmatrix} \dfrac{1}{R_{pv}C_{bus}} & 0 & \dfrac{\beta|v_g|}{C_{bus}} & -\dfrac{\gamma|v_g|}{C_{bus}} \\[3mm] 0 & 0 & -\dfrac{\beta V_{bus}}{C_g} & \dfrac{\gamma V_{bus}}{C_g} \\[3mm] 0 & -\dfrac{1}{L_g} & 0 & 0 \end{bmatrix}$$

Wherein $V_{bus}$ is the DC bus capacitor voltage, $R_{pv}$ is the output voltage of the photovoltaic panels at the point of maximum power divided by the output current, $L_g$ is filtering inductor on the AC power grid side, and the symbolic variables $\alpha$, $\beta$ and $\gamma$ are related to the modulation mode of the dual-active-bridge-type micro-inverter.

Furthermore, for mode two, the symbol variables are:

$$\begin{cases} \alpha = \dfrac{n(2D_2 - D_1^2 - 4D_2^2)}{4f_s L_k} \\[2mm] \beta = \dfrac{\partial \alpha}{\partial D_1} = -\dfrac{n \cdot 2D_1}{4f_s L_k} \\[2mm] \gamma = \dfrac{\partial \alpha}{\partial D_2} = \dfrac{n \cdot (2 - 8D_2)}{4f_s L_k} \end{cases}$$

Furthermore, for mode three, the symbol variables are:

$$\begin{cases} \alpha = \dfrac{n \cdot 2D_2(1 - 2D_1)}{4f_s L_k} \\[2mm] \beta = \dfrac{\partial \alpha}{\partial D_1} = -\dfrac{n \cdot 4D_2}{4f_s L_k} \\[2mm] \gamma = \dfrac{\partial \alpha}{\partial D_2} = \dfrac{n \cdot 2(1 - 2D_1)}{4f_s L_k} \end{cases}$$

Wherein $f_s$ is the switching frequency of the switching tube, $L_k$ is the value of the transformer leakage inductor converted to the secondary side, n is the transformer secondary-primary turns ratio, $D_1$ and $D_2$ are the internal and external phase shift angles, respectively.

The transfer function can be used to describe the quantitative variation relationship of the state variable with the input variable at different frequencies, and when the transfer function is known, the response of the state variable can be studied for various forms of input variables, in order to analyze the grid-connection stability of the micro-inverter.

The method to further analyze the dynamic performance of the micro-inverters under different circuit parameters and operating conditions is: changing the three parameters of photovoltaic terminal voltage $v_{pv}$, power grid voltage amplitude $V_m$ and grid-connection power $P_o$, and under each set of parameters, obtaining the transfer function from the input variables to the state variables by solving according to the small signal model of the micro-inverter, and analyzing the dynamic performance of the micro-inverter according to the gain, crossover frequency, amplitude margin, and phase margin of the transfer function.

The circuit modeling method provided in the above mentioned embodiments of the present invention equates a dual-active-bridge-type micro-inverter to a standard dual-active-bridge circuit by establishing an equivalent circuit model, thereby establishing a third-order large signal model and a third-order small signal model of the micro-inverter, so as to facilitate the solution of the circuit state variables, and then to realize the analysis of the grid-connection stability and dynamic performance of the micro-inverter. The circuit modeling method establishes a complete large signal and small signal model of the micro-inverter. On the one hand, it facilitates the solution of the steady-state operating point, and on the other hand, the transfer function obtained using the small signal model facilitates the study of the dynamic performance of the micro-inverter.

An embodiment of the present invention also provides an output current control method of a dual-active-bridge-type micro-inverter, wherein a small signal model of the micro-inverter is established based on the circuit modeling method according to any one of the above mentioned embodiments, a control logic of the current loop is determined according to the positive and negative of the grid-side voltage, a grid-side current error obtained through the correct control logic is inputted to a current closed-loop compensation controller, and the output of the current closed-loop compensation controller is an external phase shift angle $D_2$ of the micro-inverter which can be used for and phase shift control, to accomplish closed-loop control of the output current of the dual-active-bridge-type micro-inverter. wherein:

The control logic of the current loop is specified as follows:

When the power grid voltage $v_g$ is less than 0, the grid-side current error is $(i_g - i_{g,ref})$, wherein $i_g$ is the sampled grid-side current, and $i_{g,ref}$ is the given value of the grid-side current;

When the power grid voltage $v_g$ is greater than 0, the grid-side current error is $(i_{g,ref} - i_g)$.

Further, the current closed-loop compensation controller is a quasi-proportional resonance (Q-PR) controller with three designable control parameters, respectively: ① a bandwidth adjustment parameter $\omega_c$, ② a proportionality coefficient $K_p$, and ③ a resonance coefficient $K_r$.

The roles of the three parameters are as follows:

① The bandwidth adjustment parameter $\omega_c$: is used to change the resonance bandwidth of the frequency band characteristics of the controller, and the smaller $\omega_c$ is, the better the frequency selection characteristic is, but the worse the ability to resist power grid frequency disturbance is;

② The proportionality coefficient $K_p$: is used to improve the dynamic characteristic of the dual-active-bridge-type micro-inverter control system, the larger $K_p$ is, the shorter the response time is, but the larger the overshoot is;

③ The resonance coefficient $K_r$: is used to adjust the gain of the controller, the larger $K_r$ is, the larger the controller gain is.

The specific design principles for the control parameters of the Q-PR controller are as follows:

Step 1: according to the small signal model of the dual-active-bridge-type micro-inverter, the transfer function $G_{io,d2}(s)$ from the external phase shift angle to the output current at 3ms during the power frequency period is obtained; the open-loop gain of the current loop at the power frequency $\omega_{ac}$ is selected to be greater than or equal to $M$; the crossover frequency of the current loop open-loop transfer function is selected to be $\omega_{cr}$; and the phase margin of the current loop open-loop transfer function is selected to be greater than or equal to $\phi_{margin}$;

Step 2: according to the maximum allowable variation range of the power grid angular frequency $[-\Delta\omega_{max}, \Delta\omega_{max}]$, take $\omega_c = \Delta\omega_{max}$, wherein $\Delta\omega_{max}$ is the maximum allowable variation of the power grid angular frequency;

Step 3: the current loop open-loop transfer function $T_c(j\omega_{ac}) = G_{io,d2}(j\omega_{ac}) \cdot G_{QPR}(j\omega_{ac})$ at the power frequency $\omega_{ac}$ is obtained according to $G_{io,d2}(s)$ and the transfer function $G_{QPR}(s)$ of the Q-PR controller, let its gain be greater than or equal to $M$, an inequality constraint relationship $|G_{io,d2}(j\omega_{ac}) \cdot G_{QPR}(j\omega_{ac})| \geq M$ containing $K_p$ and $K_r$ is obtained;

Step 4: according to the property that the current loop has a gain of 1 at the crossover frequency, an equality constraint relationship $|G_{io,d2}(j\omega_{cr}) \cdot G_{QPR}(j\omega_{cr})| = 1$ containing $K_p$ and $K_r$ is obtained;

Step 5: according to the condition that the phase margin of the current loop at the crossover frequency is greater than or equal to $\phi_{margin}$, an inequality constraint relationship $\pi + angle[G_{io,d2}(j\omega_{cr}) \cdot G_{QPR}(j\omega_{cr})] \geq \phi_{margin}$ containing $K_p$ and $K_r$ is obtained.

According to the two inequality constraints and one equality constraint obtained in steps 3 to 5, the range of the proportionality coefficient $K_p$ and the resonance coefficients $K_r$ can be solved, and the appropriate control parameters can be selected accordingly.

In a specific application example, when $|v_g| \leq 10V$ is satisfied near the zero crossing point of the grid-side voltage, the current error of the input current closed-loop compensation controller is set to 0, and the calculation of the current error in other time periods is carried out in accordance with normal principle, specifically, when the power grid voltage $v_g$ is less than -10V, the current error of the grid-side is $(i_g - i_{g,ref})$; and when the power grid voltage $v_g$ is greater than 10V, the current error of the grid-side is $(i_{g,ref} - i_g)$.

The output current control method provided in the above mentioned embodiments of the present invention is an output current closed-loop control method, wherein the correct current loop control logic is established on the basis of the small signal model of the dual-active-bridge-type micro-inverter, and the current loop parameter design method is given. The output current control method is conducive to improving the grid-connection stability and the precision of the output current of the micro-inverter, by giving the correct current loop control logic and the detailed current loop parameter design method.

The circuit modeling method and the output current control method provided in the above mentioned embodiments of the present invention are further explained below in conjunction with the accompanying drawings.

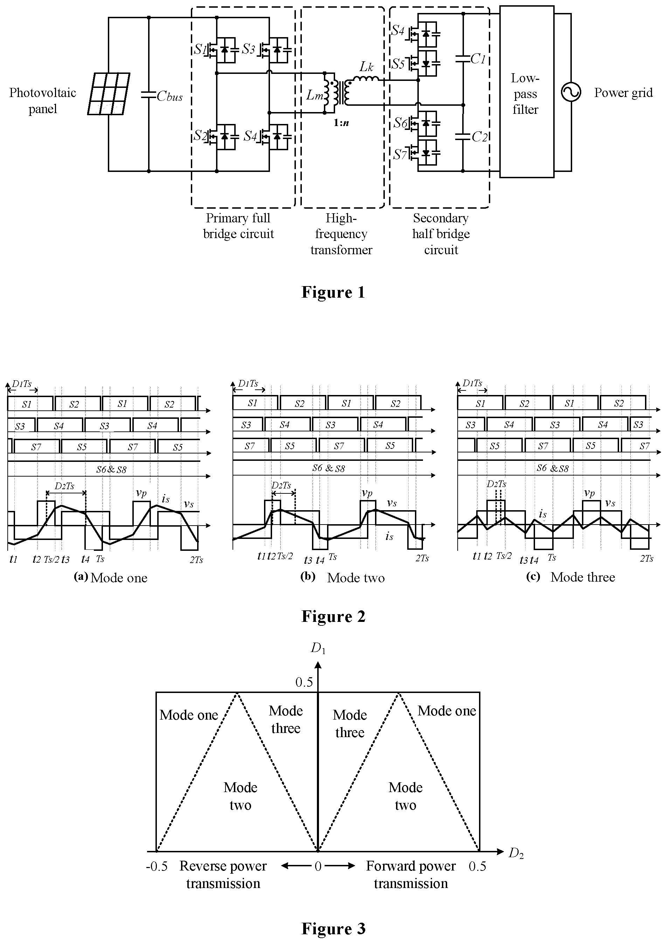

FIG.1 shows a schematic diagram of the single-stage half-bridge DAB-type micro-inverter circuit. With reference to FIG. 1, the single-stage half-bridge DAB-type micro-inverter circuit consists of a photovoltaic panel component, a DC bus capacitor, a primary side full-bridge circuit, a high-frequency transformer, a secondary side half-bridge circuit, and a grid-side low-pass filter. The primary side full-bridge circuit contains switch tubes S1~S4, and the secondary side half-bridge circuit contains switch tubes S5~S8 and thin film capacitors C1/C2; turns ratio of the primary side to the secondary side of the high-frequency transformer is 1:$n$, and the excitation inductor converted to the primary side is $L_m$, and the transformer leakage inductor converted to the secondary side is $L_k$.

FIG.2 shows the driving waveforms of switch tubes S1~S8 and the voltage and current waveforms of the primary and secondary sides of the transformer of three modulation modes of the single-stage half-bridge DAB-type micro-inverter in Example 1 of the present invention. With reference to FIG.2, the basic working mode of the single-stage half-bridge DAB-type micro-inverter is as follows: switch tubes S1 and S2 complementarily conduct at high frequencies, while switch tubes S3 and S4 complementarily conduct at high frequencies. When the grid-side voltage is positive, switch tubes S6 and S8 are normally on, and switch tubes S5 and S7 complementarily conduct at high frequencies; when the grid-side voltage is negative, switch tubes S5 and S7 are normally on, and switch tubes S6 and S8 complementarily conduct at high frequencies.

With reference to FIG.2, the single-stage half-bridge DAB-type micro-inverter transformer can output three electrical levels $\{v_{pv}, 0, -v_{pv}\}$ on the primary side, and can output two electrical levels $\{|v_g|/2, -|v_g|/2\}$ on the secondary side. Wherein $v_{pv}$ is the photovoltaic panel terminal voltage and $|v_g|$ is the absolute value of the grid-side voltage.

Further, the single-stage half-bridge DAB-type micro-inverter realizes the output power regulation by phase shift modulation, and the micro-inverter has two control degrees of freedom, which are the internal phase shift angle $D_1$ of the primary circuit and the external phase shift angle $D_2$ of the primary and secondary circuits respectively, wherein the internal phase shift angle is defined as the angle between the drive pulses of the switch tube S4 and the drive pulses of the switch tube S1, and the external phase shift angle is defined as the angle between the fundamental wave of the transformer primary side square wave voltage and the fundamental wave of the transformer secondary side square wave voltage. The range of values of $D_1$ is $0 \le D_1 \le 0.5$, and the range of values of $D_2$ is $-0.5 \le D_2 \le 0.5$.

FIG.3 shows a schematic diagram of the ranges of internal phase shift angle and external phase shift angle corresponding to the three modulation modes in Example 1 of the present invention, and with reference to FIG.3, when $D_2$ satisfies $(1-D_1)/2 < D_2 \le 0.5$ or $-0.5 < D_2 \le -(1-D_1)/2$, the corresponding modulation mode is mode one; when $D_2$ satisfies $D_1/2 < D_2 \le (1-D_1)/2$ or $-(1-D_1)/2 < D_2 \le -D_1/2$, the corresponding modulation mode is mode two; and when the external phase shift angle $D_2$ satisfies $0 \le D_2 \le D_1/2$ or $-D_1/2 \le D_2 \le 0$, the corresponding modulation mode is mode three.

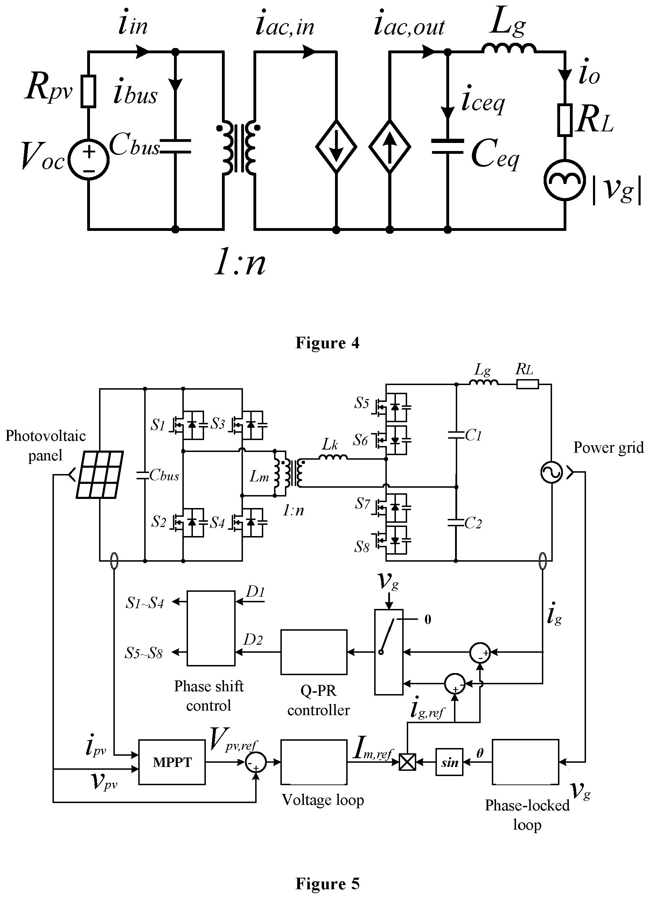

FIG.4 shows an equivalent circuit of the single-stage half-bridge DAB-type micro-inverter in Example 1 of the present invention, with reference to FIG.4, the equivalent circuit of the micro-inverter consists of a DC source $V_{oc}$, a DC source series resistor $R_{pv}$, a DC side bus capacitor $C_{bus}$, a controlled current source $i_{ac,in}$, an ideal transformer with primary and secondary side turn ratio of 1:n, a controlled current source $i_{ac,out}$, a capacitor $C_g$, a filtering inductor $L_g$ on a AC power grid side, an inductor winding resistor $R_L$.

Wherein the voltage of the DC source $V_{oc}$ is the open-circuit voltage of the photovoltaic panels; the DC source series resistor $R_{pv}$ is equal to the output voltage of the photovoltaic panels at the point of maximum power divided by the output current; the output currents of the controlled current source $i_{ac,in}$ and the controlled current source $i_{ac,out}$ vary according to the different modulation modes; the capacitance $C_{eq}$ is the series connection of C1 and C2; and the output voltage of the equivalent circuit is $|v_g|$ and the output current $i_o$ is equal to $i_s \cdot \text{sgn}(v_g)$.

According to the equivalent circuit of the single-stage half-bridge DAB-type micro-inverter shown in FIG.4, a large signal model of the circuit can be given. The large signal model of the circuit is a third-order average model $\dot{X} = A_1 X + B_1 U$; wherein $X$ is a state variable of the large signal model; $\dot{X}$ is a derivative of the state variable of the large signal model with respect to time; $U$ is an input variable of the large signal model; $A_1$ is a coefficient matrix of the state variable of the large signal model, with an order of $3 \times 3$; $B_1$ is a coefficient matrix of the input variable of the large signal model, with an order of $3 \times 2$.

The state variable $X$ of the large signal model is: $X = [\langle v_{bus} \rangle, \langle v_{cg} \rangle, \langle i_o \rangle]^T$; the input variable $U$ of the large signal model is: $U = [\langle v_{dc} \rangle, \langle v_o \rangle]^T$; wherein $\langle v_{bus} \rangle$ is an average value of the voltage of the DC side bus capacitor $C_{bus}$ during the switching period, $\langle v_{cg} \rangle$ is an average value of the voltage of the capacitor $C_g$ of the equivalent circuit during the switching period, $\langle i_o \rangle$ is an average value of the output current of the equivalent circuit during the switching period, $\langle v_{dc} \rangle$ is an average value of the input voltage of the DC side of the equivalent circuit during the switching period, and $\langle v_o \rangle$ is an average value of the output voltage of the equivalent circuit during the switching period.

The general formula of the large signal model is:

$$\frac{d}{dt}\begin{bmatrix} \langle v_{bus} \rangle \\ \langle v_{eq} \rangle \\ \langle i_o \rangle \end{bmatrix} = \begin{bmatrix} -\dfrac{1}{R_{pv}C_{bus}} & -\dfrac{\alpha}{C_{bus}} & 0 \\ \dfrac{\alpha}{C_{eq}} & 0 & -\dfrac{1}{C_{eq}} \\ 0 & \dfrac{1}{L_g} & -\dfrac{R_L}{L_g} \end{bmatrix}\begin{bmatrix} \langle v_{bus} \rangle \\ \langle v_{eq} \rangle \\ \langle i_o \rangle \end{bmatrix} + \begin{bmatrix} \dfrac{1}{R_s C_{bus}} & 0 \\ 0 & 0 \\ 0 & -\dfrac{1}{L_g} \end{bmatrix}\begin{bmatrix} \langle v_{oc} \rangle \\ \langle |v_g| \rangle \end{bmatrix}$$

Wherein a is related to the modulation mode of the micro-inverter, for mode two: $\alpha = \dfrac{n(2d_\delta - d_1^2 - 4d_\delta^2)}{4f_s L_k}$,

and for mode three: $\alpha = \dfrac{n \cdot 2d_\delta(1 - 2d_1)}{4f_s L_k}$.

According to the equivalent circuit of the single-stage half-bridge DAB-type micro-inverter shown in FIG.4, a small signal model of the circuit can be given. The small signal model of the circuit is a third-order model $\dot{x} = A_2 x + B_2 u$; wherein $x$ is a state variable of the small signal model; $\dot{x}$ is a derivative of the state variable of the small signal model; $u$ is an input variable of the small signal model; $A_2$ is a coefficient matrix of the state variable of the small signal model, with an order of $3 \times 3$; $B_1$ is a coefficient matrix of the input variable of the small signal model, with an order of $3 \times 4$.

The state variable $x$ of the small signal model is: $x = \begin{bmatrix} \widehat{v_{bus}}, & \widehat{v_{cg}}, & \widehat{i_o} \end{bmatrix}^T$ ; the input variable $u$ of the small signal model is: $u = \begin{bmatrix} \widehat{v_{dc}}, & \widehat{v_o}, & \widehat{d_1}, & \widehat{d_2} \end{bmatrix}^T$ ; wherein $\widehat{v_{bus}}$ is a perturbation value of the voltage of the DC side bus capacitor of the equivalent circuit, $\widehat{v_{ceq}}$ is a perturbation value of the voltage of the capacitor $C_{eq}$ of the equivalent circuit, $\widehat{i_o}$ is a perturbation value of the output current of the equivalent circuit, $\widehat{v_{dc}}$ is a perturbation value of the input voltage of the DC side of the equivalent circuit, $\widehat{v_o}$ is a perturbation value of the output voltage of the equivalent circuit, $\widehat{d_1}$ is a perturbation value of the internal phase shift angle, $\widehat{d_2}$ is a perturbation value of the external phase shift angle.

The general formula of the small signal model is:

$$
\frac{d}{dt}\begin{bmatrix} \widehat{v_{bus}} \\ \widehat{v_{eq}} \\ \widehat{i_o} \end{bmatrix} = \begin{bmatrix} -\dfrac{1}{R_{pv}C_{bus}} & -\dfrac{\alpha}{C_{bus}} & 0 \\ \dfrac{\alpha}{C_{eq}} & 0 & -\dfrac{1}{C_{eq}} \\ 0 & \dfrac{1}{L_g} & -\dfrac{R_L}{L_g} \end{bmatrix}\begin{bmatrix} \widehat{v_{bus}} \\ \widehat{v_{eq}} \\ \widehat{i_o} \end{bmatrix} + \begin{bmatrix} \dfrac{1}{R_{pv}C_{bus}} & 0 & \dfrac{\beta V_{eq}}{C_{bus}} & -\dfrac{\gamma V_{eq}}{C_{bus}} \\ 0 & 0 & -\dfrac{\beta V_{bus}}{C_{eq}} & \dfrac{\gamma V_{bus}}{C_{eq}} \\ 0 & -\dfrac{1}{L_g} & 0 & 0 \end{bmatrix}\begin{bmatrix} \widehat{v_{oc}} \\ |\widehat{v_g}| \\ \widehat{d_1} \\ \widehat{d_\delta} \end{bmatrix}
$$

Wherein the symbol variables $\alpha, \beta, \gamma$ are related to the modulation modes, and for mode two, the symbol variables are:

$$
\begin{cases} \alpha = \dfrac{n(2D_2 - D_1^2 - 4D_2^2)}{4f_s L_k} \\ \beta = \dfrac{\partial \alpha}{\partial D_1} = -\dfrac{n \cdot 2D_1}{4f_s L_k} \\ \gamma = \dfrac{\partial \alpha}{\partial D_2} = \dfrac{n \cdot (2 - 8D_2)}{4f_s L_k} \end{cases}
$$

For mode three, the symbol variables are:

$$
\begin{cases} \alpha = \dfrac{n \cdot 2D_2(1 - 2D_1)}{4f_s L_k} \\ \beta = \dfrac{\partial \alpha}{\partial D_1} = -\dfrac{n \cdot 4D_2}{4f_s L_k} \\ \gamma = \dfrac{\partial \alpha}{\partial D_2} = \dfrac{n \cdot 2(1 - 2D_1)}{4f_s L_k} \end{cases}
$$

The small signal model of the single-stage half-bridge DAB-type micro-inverter according to the above mentioned can be used to solve the transfer function from the four input variables to the three state variables, the specific solution method is:

$$
x = (sI - A_2)^{-1}B_2 u
$$

Wherein I is a diagonal matrix with diagonal element 1, with an order of $3 \times 3$; s is the Laplace domain symbol.

The overall control block diagram of the single-stage half-bridge DAB-type micro-inverter in Example 2 of the present invention is shown in FIG.5. With reference to FIG.5, the control block diagram is divided into six parts: maximum power point tracking (MPPT), voltage loop, phase-locked loop, current loop, feedforward control and phase shift control. After sampling the terminal voltage $v_{pv}$ and output current $i_{pv}$ of the photovoltaic panel, the controller generates the given value of the terminal voltage of the photovoltaic panel $V_{pv,ref}$ after passing through the maximum power point tracking (MPPT) segment; the amplitude of the given value of the grid-side current $I_m$ is generated by passing the difference between $V_{pv,ref}$ and the actual sampled voltage $v_{pv}$ through the voltage loop; the controller samples the grid-side voltage $v_g$ and generates the phase $\theta$ of the grid-side voltage through the phase-locked loop; $\theta$, after sine transformation, is multiplied with $I_m$ to obtain the given value of the grid-side current $i_{g,ref}$ and make a difference with the actual grid-side current sampling value $i_g$, after a certain control logic, the external phase shift angle $D_2$ is obtained through the current closed-loop compensation controller; the internal phase shift angle $D_1$ generates drive signals S1~S4 through the phase shift controller, and the external phase shift angle $D_2$ generates drive signals S5~S8 through the phase shift controller, such that the single-stage half-bridge DAB-type micro-inverter outputs the given power.

Further, the control logic of the current loop is specified as follows:

When the power grid voltage $v_g$ is less than 0, the grid-side current error is $(i_g - i_{g,ref})$, wherein $i_g$ is the sampled grid-side current, and $i_{g,ref}$ is the given value of the grid-side current;
When the power grid voltage $v_g$ is greater than 0, the grid-side current error is $(i_{g,ref} - i_g)$.

The current error of the input current closed-loop compensation controller is 0 near the zero crossing point of the grid-side voltage, i.e., when $|v_g| \leq 10V$ is satisfied.

Further, the current closed-loop compensation controller is a quasi-proportional resonance (Q-PR) controller with three designable control parameters, respectively: ① a bandwidth adjustment parameter $\omega_c$, ② a proportionality coefficient $K_p$, and ③ a resonance coefficient $K_r$.

Specifically, the roles of the three parameters are as follows:

① The bandwidth adjustment parameter $\omega_c$: is used to change the resonance bandwidth of the frequency band characteristics of the controller, the smaller $\omega_c$ is, the better the frequency selection characteristic is, but the worse the ability to resist power grid frequency disturbance is;

② The proportionality coefficient $K_p$: is used to improve the dynamic characteristics of the system, the larger $K_p$ is, the shorter the response time is, but the larger the overshoot is;

③ The resonance coefficient $K_r$: is used to adjust the gain of the controller, the larger $K_r$ is, the larger the controller gain is.

Specifically, the specific design principles of the Q-PR controller are as follows:

Step 1: according to the small signal model of the single-stage half-bridge DAB-type micro-inverter, the transfer function $G_{io,d2}(s)$ from the external phase shift angle to the output current at 3ms during the power frequency period is obtained; the open-loop gain of the current loop at the power frequency $\omega_{ac}$ is selected to be greater than or equal to $M$; the crossover frequency of the current loop open-loop transfer function is selected to be $\omega_{cr}$; and the phase margin of the current loop open-loop transfer function is selected to be greater than or equal to $\phi_{margin}$;
Step 2: according to the maximum allowable variation range of the power grid angular frequency $[-\Delta\omega_{max}, \Delta\omega_{max}]$, take $\omega_c = \Delta\omega_{max}$, wherein $\Delta\omega_{max}$ is the maximum allowable variation of the power grid angular frequency;
Step 3: the current loop open-loop transfer function $T_c(j\omega_{ac}) = G_{io,d2}(j\omega_{ac}) \cdot G_{QPR}(j\omega_{ac})$ at the power frequency $\omega_{ac}$ is obtained according to $G_{io,d2}(s)$ and the transfer function $G_{QPR}(s)$ of the Q-PR controller, let its gain be greater than or equal to $M$, an inequality constraint relationship $|G_{io,d2}(j\omega_{ac}) \cdot G_{QPR}(j\omega_{ac})| \geq M$ containing $K_p$ and $K_r$ is obtained;
Step 4: according to the property that the current loop has a gain of 1 at the crossover frequency, an equality constraint relationship $|G_{io,d2}(j\omega_{cr}) \cdot G_{QPR}(j\omega_{cr})| = 1$ containing $K_p$ and $K_r$ is obtained;
Step 5: according to the condition that the phase margin of the current loop at the crossover frequency is greater than or equal to $\phi_{margin}$, an inequality constraint relationship $\pi + angle[G_{io,d2}(j\omega_{cr}) \cdot G_{QPR}(j\omega_{cr})] \geq \phi_{margin}$ containing $K_p$ and $K_r$ is obtained.

According to the two inequality constraints and one equality constraint obtained in steps 3 to 5, so that the range of the proportionality coefficient $K_p$ and the resonance coefficients $K_r$ can be solved, and the appropriate control parameters can be selected accordingly.

Of course, the specific circuits of the above embodiments are only preferred embodiments of one implementation of the present invention, and are not intended to limit the present invention, and in other embodiments may also be other forms of circuits realizing the same function.

The circuit modeling method of a dual-active-bridge-type micro-inverter in the above embodiment of the present invention establishes a complete third-order micro-inverter large signal and small signal model. On the one hand, it facilitates the solution of the steady-state operating point, and on the other hand, the small signal model enables further study the dynamic performance of the micro-inverter, and provides guidance for the design of control parameters.

The output current control method of a dual-active-bridge-type micro-inverter in the above embodiment of the present invention gives a correct current loop control logic and an exhaustive current loop parameter design method, which is conducive to improving the grid-connection stability and output current accuracy of the micro-inverter.

Matters not mentioned in the above embodiments of the present invention are all well-known in the art.

The specific embodiments of the present invention have been described above. It should be understood that the present invention is not limited to the specific embodiments described above, and those skilled in the art may make various deformations or modifications within the scope of the claims, which do not affect the substantive content of the present invention.

## Claims

1. A circuit modeling method for a dual-active-bridge-type micro-inverter, **characterized in that**, equating the micro-inverter to a standard dual-active-bridge-type circuit by establishing an equivalent circuit model for the dual-active-bridge-type micro-inverter, thereby further establishing a large signal model and a small signal model for the micro-inverter, completing the circuit modeling of the dual-active-bridge-type micro-inverter; wherein:
   establishing an equivalent circuit model for the dual-active-bridge-type micro-inverter, comprising:

   constructing a DC source $V_{oc}$, a DC source series resistor $R_{pv}$, a DC side bus capacitor $C_{bus}$, a controlled current source $i_{ac,in}$, an ideal transformer with a primary side to a secondary side turn ratio of 1:n, a controlled current source $i_{ac,out}$, a capacitor $C_g$, a filtering inductor $L_g$ on a AC power grid side, an inductor winding resistor $R_L$, and a DC pulsating source $|v_g|$; the positive pole of the DC source $V_{oc}$ is connected with one end of the DC source series resistor $R_{pv}$, the other end of DC source series resistor $R_{pv}$ is connected with the positive pole of the DC side bus capacitor $C_{bus}$, the positive pole of the DC side bus capacitor $C_{bus}$ is simultaneously connected with the positive pole of the primary side of the ideal transformer, the negative pole of the primary side of the ideal transformer is connected with the negative pole of the DC source $V_{oc}$, the positive pole of the secondary side of the ideal transformer is connected with the negative pole of the controlled current source $i_{ac,in}$, the negative pole of the secondary side of the ideal transformer is connected with the positive pole of the controlled current source $i_{ac,in}$ and simultaneously connected with the negative pole of the controlled current source $i_{ac,out}$, the positive pole of the controlled current source $i_{ac,out}$ is connected with the positive pole of the capacitor $C_g$ and simultaneously connected with one end of the filtering inductor $L_g$ on the AC power grid side, the other end of the inductor $L_g$ on the AC power grid side is connected with one end of the inductor winding resistor $R_L$, and the other end of the inductor winding resistor $R_L$ is connected with the positive pole of the DC pulsating source $|v_g|$, and the negative pole of the DC pulsating source $|v_g|$ is connected with the negative pole of the capacitor $C_g$;
   the established large signal model for the micro-inverter is: a third-order average model $X = A_1 X + B_1 U$; wherein $X$ is a state variable of the large signal model; $X$ is a derivative of the state variable of the large signal model with respect to time; $U$ is an input variable of the large signal model; $A_1$ is a coefficient matrix of the state variable of the large signal model; $B_1$ is a coefficient matrix of the input variable of the large signal model; the state variable $X$ of the large signal model is: $X = [\langle v_{bus} \rangle, \langle v_{cg} \rangle, \langle i_o \rangle]^T$; the input variable $U$ of the large signal model is: $U = [\langle v_{ac} \rangle, \langle v_o \rangle]^T$; wherein $\langle v_{bus} \rangle$ is an average value of the voltage of the DC side bus capacitor $C_{bus}$ of the equivalent circuit during the switching period, $\langle v_{cg} \rangle$ is an average value of the voltage of the capacitor $C_g$ of the equivalent circuit during the switching period, $\langle i_o \rangle$ is an average value of the output current of the equivalent circuit during the switching period, $\langle v_{dc} \rangle$ is an average value of the input voltage of the DC side of the equivalent circuit during the switching period, and $\langle v_o \rangle$ is an average value of the output voltage of the equivalent circuit during the switching period;
   the established small signal model for the micro-inverter is: a third-order model $\dot{x} = A_2 x + B_2 u$; wherein $x$ is a state variable of the small signal model; $\dot{x}$ is a derivative of the state variable of the small signal model; $u$ is an input variable of the small signal model; $A_2$ is a coefficient matrix of the state variable of the small signal model; $B_1$ is a coefficient matrix of the input variable of the small signal model; the state variable $x$ of the small signal model is:

   $$x = \left[\widehat{v_{bus}},\ \widehat{v_{cg}},\ \hat{i_o}\right]^T$$ ; the input variable $u$ of the small signal model is: $$u = \left[\widehat{v_{dc}},\ \widehat{v_o},\ \hat{d_1},\ \hat{d_2}\right]^T$$ ; wherein

   $\widehat{v_{bus}}$ is a perturbation value of the voltage of the DC side bus capacitor $C_{bus}$ of the equivalent circuit, $\widehat{v_{cg}}$ is a

perturbation value of the voltage of the capacitor $C_g$ of the equivalent circuit, $\widehat{i_o}$ is a perturbation value of the output current of the equivalent circuit, $\widehat{v_{dc}}$ is a perturbation value of the input voltage of the DC side of the equivalent circuit, $\widehat{v_o}$ is a perturbation value of the output voltage of the equivalent circuit, $\widehat{d_1}$ is a perturbation value of the internal phase shift angle, $\widehat{d_2}$ is a perturbation value of the external phase shift angle.

2. The circuit modeling method for the dual-active-bridge-type micro-inverter according to claim 1, **characterized in that**, in the equivalent circuit model of the dual-active-bridge-type micro-inverter, the voltage of the DC source $V_{oc}$ is the open-circuit voltage of the photovoltaic panels; the DC source series resistor $R_{pv}$ is equal to the output voltage of the photovoltaic panels at the point of maximum power divided by the output current; the output currents of the controlled current source $i_{ac,in}$ and the controlled current source $i_{ac,out}$ vary according to the different modulation modes of the dual-active-bridge-type micro-inverter;
the DC pulsating source $|v_g|$ is the output voltage of the equivalent circuit model, and the output current of the equivalent circuit model $i_o$ is equal to $i_g \cdot \text{sgn}(v_g)$, wherein $i_g$ is a sampled grid-side current, and $\text{sgn}(v_g)$ is a sign function of the grid-side voltage.

3. The circuit modeling method for the dual-active-bridge-type micro-inverter according to claim 1, **characterized in that**, the large signal model of the micro-inverter is used to solve the variation relationship of the state variable $X$ with the input variable $U$, the variation relationship obtained by solving is used to analyze the steady-state operating point of the circuit, and the small signal model is solved and analyzed at the obtained steady-state operating point.

4. The circuit modeling method for the dual-active-bridge-type micro-inverter according to claim 1, **characterized in that**, the small signal model of the micro-inverter is used to solve a transfer function from four input variables to three state variables, further used to analyze the grid-connection stability and dynamic performance of the micro-inverter under different circuit parameters and operating conditions; wherein:

the four input variables are $u = \left[\widehat{v_{dc}}, \widehat{v_o}, \widehat{d_1}, \widehat{d_2}\right]^T$, the three state variables are $x = \left[\widehat{v_{bus}}, \widehat{v_{cg}}, \widehat{i_o}\right]^T$, and the expression of the transfer function is:

$$x = (sI - A_2)^{-1} B_2 u$$

wherein $I$ is a diagonal matrix with diagonal element 1; s is the Laplace domain symbol; and the expressions of the matrices $A_2$ and $B_2$ are:

$$A_2 = \begin{bmatrix} -\dfrac{1}{R_{pv}C_{bus}} & -\dfrac{\alpha}{C_{bus}} & 0 \\ \dfrac{\alpha}{C_g} & 0 & -\dfrac{1}{C_g} \\ 0 & \dfrac{1}{L_g} & -\dfrac{R_L}{L_g} \end{bmatrix}$$

$$B_2 = \begin{bmatrix} \dfrac{1}{R_{pv}C_{bus}} & 0 & \dfrac{\beta|v_g|}{C_{bus}} & -\dfrac{\gamma|v_g|}{C_{bus}} \\ 0 & 0 & -\dfrac{\beta V_{bus}}{C_g} & \dfrac{\gamma V_{bus}}{C_g} \\ 0 & -\dfrac{1}{L_g} & 0 & 0 \end{bmatrix}$$

**wherein** $V_{bus}$ is the DC bus capacitor voltage, $R_{pv}$ is the output voltage of the photovoltaic panels at the point of maximum power divided by the output current, $L_g$ is the filtering inductor on the AC power grid side, and the symbolic variables $\alpha$, $\beta$ and $\gamma$ are related to the modulation mode of the dual-active-bridge-type micro-inverter.

5. The circuit modeling method for the dual-active-bridge-type micro-inverter according to claim 2 or 4, **characterized in that**, the modulation mode of the dual-active-bridge-type micro-inverter, comprising:

the angle between the negative rising edge of the transformer primary side square wave voltage and the positive rising edge of the transformer primary side square wave voltage is positioned as the internal phase shift angle $D_1$, the angle between the fundamental wave of the transformer primary side square wave voltage and the fundamental wave of the transformer secondary side square wave voltage is defined as the external phase shift angle $D_2$, and the internal phase shift angle $D_1$ and the external phase shift angle $D_2$ are taken as two control degrees of freedom for the dual-active-bridge-type micro-inverter, wherein the range of values of $D_1$ is $0 \leq D_1 \leq 0.5$, and the range of values of $D_2$ is $-0.5 \leq D_2 \leq 0.5$;

according to the two control degrees of freedom, the modulation mode of transmission power is divided into mode one, mode two and mode three, wherein: when the external phase shift angle $D_2$ satisfies $(1 - D_1)/2 < D_2 \leq 0.5$ or $-0.5 < D_2 \leq -(1- D_1)/2$ , the positive electrical level part of the primary side square wave voltage completely coincides with the negative level part of the secondary side square wave voltage, the corresponding modulation mode is mode one, at this time, the output currents of the controlled current source $i_{ac,in}$ and the controlled current source $i_{ac,out}$ are close to a sine wave, and the effective value of output current is maximum; when the external phase shift angle $D_2$ satisfies $0 \leq D_2 \leq D_1/2$ or $- D_1/2 \leq D_2 \leq 0$, the positive electrical level part of the primary side square wave voltage completely coincides with the positive level part of the secondary side square wave voltage, the corresponding modulation mode is mode three, at this time, the output currents of the controlled current source $i_{ac,in}$ and the controlled current source $i_{ac,out}$ are close to a triangular wave, and the effective value of output current is minimum; when the external phase shift angle $D_2$ satisfies $D_1/2 < D_2 \leq (1- D_1)/2$ or $-(1- D_1)/2 < D_2 \leq - D_1/2$ , one part of the positive electrical level of the primary side square wave voltage coincides with the positive electrical level of the secondary side square wave voltage, the other part of the positive electrical level of the primary side square wave voltage coincides with the negative electrical level of the secondary side square wave voltage, the corresponding modulation mode is mode two, at this time, the output currents of the controlled current source $i_{ac,in}$ and the controlled current source $i_{ac,out}$ are close to a trapezoidal wave, the effective value of the output current is less than the effective value in mode one and greater than the effective value in mode three.

6. The circuit modeling method for the dual-active-bridge-type micro-inverter according to claim 5, **characterized in that**, for the mode two, the symbol variables $\alpha$, $\beta$ and $\gamma$ are respectively:

$$\begin{cases} \alpha = \dfrac{n(2D_2 - D_1^2 - 4D_2^2)}{4f_s L_k} \\[2ex] \beta = \dfrac{\partial \alpha}{\partial D_1} = -\dfrac{n \cdot 2D_1}{4f_s L_k} \\[2ex] \gamma = \dfrac{\partial \alpha}{\partial D_2} = \dfrac{n \cdot (2 - 8D_2)}{4f_s L_k} \end{cases}$$

for the mode three, the symbol variables $\alpha$, $\beta$ and $\gamma$ are respectively:

$$\begin{cases} \alpha = \dfrac{n \cdot 2D_2(1 - 2D_1)}{4f_s L_k} \\[2ex] \beta = \dfrac{\partial \alpha}{\partial D_1} = -\dfrac{n \cdot 4D_2}{4f_s L_k} \\[2ex] \gamma = \dfrac{\partial \alpha}{\partial D_2} = \dfrac{n \cdot 2(1 - 2D_1)}{4f_s L_k} \end{cases}$$

wherein $f_s$ is the switching frequency of the switching tube, $L_k$ is the value of the transformer leakage inductor converted to the secondary side, $n$ is the transformer secondary-primary turns ratio, $D_1$ and $D_2$ are the internal and external phase shift angles, respectively; and the symbolic variables $\alpha$, $\beta$ and $\gamma$ are related to the modulation mode of the dual-active-bridge-type micro-inverter.

7. An output current control method of a dual-active-bridge-type micro-inverter, **characterized in that**, based on the small signal model of the micro-inverter established by the circuit modeling method according to any one of claims 1-6, a control logic of the current loop is determined according to the positive and negative of the grid-side voltage, a grid-side current error is obtained through the determined control logic and inputted to a current closed-loop compensation controller, and the output of the current closed-loop compensation controller is an external phase shift angle $D_2$ of the micro-inverter, and phase shift control is carried out through the external phase shift angle $D_2$ to accomplish closed-loop control of the output current of the dual-active-bridge-type micro-inverter; wherein:
the control logic of the current loop comprises:

when the power grid voltage $v_g$ is less than 0, the grid-side current error is ($i_g$ - $i_{g,ref}$), wherein $i_g$ is the sampled grid-side current, and $i_{g,ref}$ is the given value of the grid-side current;
when the power grid voltage $v_g$ is greater than 0, the grid-side current error is ($i_{g,ref}$ - $i_g$).

8. The output current control method of a dual-active-bridge-type micro-inverter according to claim 7, **characterized in that**, the current closed-loop compensation controller uses a quasi-proportional resonant controller, and the quasi-proportional resonance controller has three control parameters, respectively: a bandwidth adjustment parameter $\omega_c$, a proportionality coefficient $K_p$ and a resonance coefficient $K_r$; wherein:

the bandwidth adjustment parameter $\omega_c$: is used to change the resonance bandwidth of the frequency band characteristics of the current closed-loop compensation controller, the smaller $\omega_c$ is, the better the frequency selection characteristics are, but the worse the ability to resist power grid frequency disturbance is;
the proportionality coefficient $K_p$: is used to improve the dynamic characteristics of the dual-active-bridge-type micro-inverter control system, the larger $K_p$ is, the shorter the response time is, but the larger the overshoot is;
the resonance coefficient $K_r$ : is used to adjust the gain of the current closed-loop compensation controller, the larger $K_r$ is, the larger the controller gain is.

9. The output current control method of a dual-active-bridge-type micro-inverter according to claim 8, **characterized in that**, the design method for the control parameters of the quasi-proportional resonance controller, comprising:

according to the small signal model of the dual-active-bridge-type micro-inverter, obtaining the current loop open-loop transfer function $G_{io,d2}(s)$ from the external phase shift angle $D_2$ to the output current at the set time during the power frequency period; selecting the open-loop gain of the current loop at the power frequency $\omega_{ac}$ to be greater than or equal to $M$; selecting the crossover frequency of the current loop open-loop transfer function to be $\omega_{cr}$; and selecting the phase margin of the current loop open-loop transfer function to be greater than or equal to $\phi_{margin}$; according to the maximum allowable variation range of the power grid angular frequency [- $\Delta\omega_{max}$, $\Delta\omega_{max}$] , taking $\omega_c = \Delta\omega_{max}$ , wherein $\Delta\omega_{max}$ is the maximum allowable variation of the power grid angular frequency;
obtaining the current loop open-loop transfer function $T_c(j\omega_{ac}) = G_{io,d2}(j\omega_{ac}) \cdot G_{QPR}(j\omega_{ac})$ at the power frequency $\omega_{ac}$ according to the current loop open-loop transfer function $G_{io,d2}(s)$ and the transfer function $G_{QPR}(s)$ of the quasi-proportional resonance controller, wherein j is an imaginary unit, letting the gain of the current loop open-loop transfer function $T_c (j\omega_{ac})$ at the power frequency $\omega_{ac}$ be greater than or equal to $M$, obtaining an inequality constraint relationship $|G_{io,d2}(j\omega_{ac}) \cdot G_{QPR}(j\omega_{ac})| \geq M$ containing the proportionality coefficient $K_p$ and the resonance coefficient $K_r$;
according to the property that the current loop has a gain of 1 at the crossover frequency $\omega_{cr}$, obtaining an equality constraint relationship $|G_{io,d2}(j\omega_{cr}) \cdot G_{QPR}(j\omega_{cr})|$ = 1 containing the proportionality coefficient $K_p$ and the resonance coefficient $K_r$;
according to the condition that the phase margin of the current loop at the crossover frequency $\omega_c$, needs to be greater than or equal to $\phi_{margin}$ , obtaining an inequality constraint relationship $\pi + angle \, [G_{io,d2}(j\omega_{cr}) \cdot G_{QPR}(j\omega_{cr})] \geq \phi_{margin}$ containing $K_p$ and $K_r$;
according to the two inequality constraints relationship and one equality constraint relationship obtained above, the range of the proportionality coefficient $K_p$ and the resonance coefficients $K_r$ can be solved, and the control parameters can be obtained accordingly.

10. The output current control method of a dual-active-bridge-type micro-inverter according to claim 7, **characterized in that**, further comprising:

when $|v_g| \leq 10V$ is satisfied near the zero crossing point of the grid-side voltage, the current error of the input current closed-loop compensation controller is set to 0;

when the power grid voltage $v_g$ is less than *-10V,* the current error of the grid-side is $(i_g - i_{g,ref})$;

when the power grid voltage $v_g$ is greater than *10V,* the current error of the grid-side is $(i_{g,ref} - i_g)$.

**Figure 1**

**(a)** Mode one      **(b)** Mode two      **(c)** Mode three

**Figure 2**

**Figure 3**

**Figure 4**

**Figure 5**

| INTERNATIONAL SEARCH REPORT | International application No. |
|---|---|
| | **PCT/CN2023/092409** |

| **A.** | **CLASSIFICATION OF SUBJECT MATTER** |
|---|---|

H02M7/5387(2007.01)i; H02M1/12(2006.01)i; H02J3/38(2006.01)i

According to International Patent Classification (IPC) or to both national classification and IPC

| **B.** | **FIELDS SEARCHED** |
|---|---|

Minimum documentation searched (classification system followed by classification symbols)

IPC: H02M H02J

Documentation searched other than minimum documentation to the extent that such documents are included in the fields searched

Electronic data base consulted during the international search (name of data base and, where practicable, search terms used)

CNTXT, ENTXT, ENTXTC, DWPI, WPABS, CNKI, IEEE: 大信号, 小信号, 扰动, 建模, 模型, 电流, 双有源, dual active, large signal, small signal, disturb+, current, model+

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| PX | CN 115021570 A (SHANGHAI JIAO TONG UNIVERSITY) 06 September 2022 (2022-09-06)<br>claims 1-10 | 1-10 |
| A | CN 110518801 A (HANGZHOU DIANZI UNIVERSITY et al.) 29 November 2019 (2019-11-29)<br>description, paragraphs 2-156, and figures 1-6 | 1-10 |
| A | CN 110336318 A (SHAANXI UNIVERSITY OF SCIENCE AND TECHNOLOGY) 15 October 2019 (2019-10-15)<br>entire document | 1-10 |
| A | CN 111985066 A (NORTHEAST ELECTRIC POWER UNIVERSITY et al.) 24 November 2020 (2020-11-24)<br>entire document | 1-10 |
| A | CN 112910265 A (HUAZHONG UNIVERSITY OF SCIENCE AND TECHNOLOGY) 04 June 2021 (2021-06-04)<br>entire document | 1-10 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **14 June 2023** | **30 June 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

| INTERNATIONAL SEARCH REPORT | International application No. |
| --- | --- |
| | **PCT/CN2023/092409** |

**C. DOCUMENTS CONSIDERED TO BE RELEVANT**

| Category* | Citation of document, with indication, where appropriate, of the relevant passages | Relevant to claim No. |
| --- | --- | --- |
| A | CN 113098287 A (BEIJING INSTITUTE OF MECHANICAL EQUIPMENT) 09 July 2021 (2021-07-09)<br>entire document | 1-10 |
| A | Hamid Daneshpajooh et al. "Modeling of the Phase Shift Plus Duty Cycle Controlled Half Bridge DC to DC Converter"<br>*Intelec 2013; 35th International Telecommunications Energy Conference, SMART POWER AND EFFICIENCY,* 20 November 2013 (2013-11-20),<br>entire document | 1-10 |
| A | 童安平 等 (TONG, Anping et al.). "基于离散迭代模型的DAB变换器等效电路研究 (Non-official translation: Research on Equivalent Circuit of DAB Converter Based on Discrete Iterative Model)"<br>*中国电机工程学报 (Proceedings of the CSEE),*<br>Vol. 39, No. (4), 20 February 2019 (2019-02-20),<br>pp. 1138-1149 | 1-10 |

Form PCT/ISA/210 (second sheet) (July 2022)

**INTERNATIONAL SEARCH REPORT**
Information on patent family members

International application No.

**PCT/CN2023/092409**

| Patent document cited in search report | | | Publication date (day/month/year) | Patent family member(s) | | | Publication date (day/month/year) |
|---|---|---|---|---|---|---|---|
| CN | 115021570 | A | 06 September 2022 | None | | | |
| CN | 110518801 | A | 29 November 2019 | CN | 110518801 | B | 08 December 2020 |
| CN | 110336318 | A | 15 October 2019 | None | | | |
| CN | 111985066 | A | 24 November 2020 | None | | | |
| CN | 112910265 | A | 04 June 2021 | CN | 112910265 | B | 29 March 2022 |
| CN | 113098287 | A | 09 July 2021 | None | | | |

Form PCT/ISA/210 (patent family annex) (July 2022)

# EP 4 535 639 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109408904 A

- CN 109193707 B